# FASCICULE DE BREVET EUROPEEN

(11) **EP 1 060 283 B1**
(45) Date de publication et mention de la délivrance du brevet: **26.09.2001**
(21) Numéro de dépôt: 99904938.0
(22) Date de dépôt: 23.02.1999
(51) Int. Cl.: C23C 14/04

(54) **CACHE DE REPARTITION POUR DEPOT PAR EVAPORATION SOUS VIDE**
VERTEILUNGSMASKE ZUR BESCHICHTUNG MITTELS VAKUUMVERDAMPFUNG
DISTRIBUTION MASK FOR DEPOSITING BY VACUUM EVAPORATION

(30) Priorité: 24.02.1998 FR 9802177
(43) Date de publication de la demande: 20.12.2000
(73) Titulaire: ESSILOR INTERNATIONAL (Compagnie Générale d'Optique), F-94220 Charenton-le-Pont (FR)
(72) Inventeur: BEINAT, Olivier, F-55000 Longeville en Barrois (FR); CONTE, Dominique, F-52100 Saint-Dizier (FR)
(74) Mandataire: Barbin le Bourhis, Joel
(86) Numéro de dépôt international: FR9900405
(87) Numéro de publication internationale: WO9943863

(56) Documents cités:
- WO-A-92/07104
- PATENT ABSTRACTS OF JAPAN vol. 014, no. 580 (E-1017), 25 décembre 1990 & JP 02 251143 A (SUMITOMO ELECTRIC IND LTD), 8 octobre 1990
- ANONYMOUS: "Uniformity Deposition Corrector. October 1971." IBM TECHNICAL DISCLOSURE BULLETIN, vol. 14, no. 5, octobre 1971, page 1572 XP002083820 New York, US

## Description

La présente invention concerne d'une manière générale le dépôt par évaporation d'un quelconque revêtement sur un quelconque substrat.

Elle vise plus particulièrement, mais non nécessairement exclusivement, le cas où ce substrat est une lentille ophtalmique.

Quelle que soit la nature minérale, organique ou composite, de leur matière constitutive, il est connu qu'il est parfois nécessaire d'appliquer après fabrication aux lentilles ophtalmiques un quelconque traitement de surface de nature à en renforcer certaines caractéristiques ou de nature à leur conférer des caractéristiques particulières.

Il peut s'agir, par exemple, d'un traitement antireflet et/ou d'un traitement de durcissement.

La présente invention vise plus particulièrement, encore, le cas où la réalisation d'un tel traitement se fait par dépôt d'un revêtement formé d'au moins une couche de matériau, et où, pour un tel dépôt, il est procédé par évaporation, et, plus précisément, par évaporation sous vide.

Le plus souvent, le revêtement est un revêtement multicouches, c'est-à-dire un revêtement impliquant l'empilement de plusieurs couches les unes sur les autres.

Les diverses couches ainsi mises en oeuvre peuvent être constituées de matériaux différents, de matériaux identiques déposés sous des épaisseurs différentes, ou, encore, de matériaux identiques déposés sous des épaisseurs identiques.

Dans ce dernier cas, les couches sont déposées avec des paramètres d'évaporation différents, de sorte que leurs propriétés physico-chimiques sont différentes.

Par exemple, pour un traitement antireflet, il est ainsi couramment procédé à un empilement d'au moins six couches à l'aide de quatre matériaux différents, à savoir une couche d'accrochage, quatre couches répondant aux effets optiques recherchés, et une couche hydrophobe.

Le plus souvent, également, un grand nombre de substrats sont traités en même temps, et l'enceinte de traitement mise en oeuvre pour ce faire comporte, intérieurement, d'une part, un support, qui, monté rotatif, présente, répartis autour de son axe de rotation, une pluralité d'emplacements propres à recevoir chacun un substrat à traiter, et qui, en pratique, est globalement en forme de calotte sphérique, et, d'autre part, une source émettrice, à partir de laquelle le matériau à déposer est évaporé.

En pratique, cette source émettrice est constituée par un support sur lequel est disposé le matériau à évaporer, par exemple un creuset ou une platine, et, pour son évaporation, le matériau est par exemple soumis à un échauffement par effet Joule, à un bombardement électronique, ou à un effet de pulvérisation cathodique.

Dans tous les cas, l'une des difficultés à surmonter tient à ce que, pour des raisons évidentes, il importe que le ou les dépôts effectués se fassent de manière uniforme sur chacun des substrats, et qu'ils soient identiques pour l'ensemble de ceux-ci.

Or, le cône d'évaporation d'un matériau n'est en pratique pas isotrope.

Il n'est pas rare, dans ces conditions, d'observer une différence entre les épaisseurs des couches d'un substrat à un autre, en fonction du matériau déposé, des paramètres conditionnant l'évaporation de celui-ci, de la géométrie de l'enceinte de traitement mise en oeuvre, et de la position de la source émettrice dans cette enceinte de traitement.

Pour minimiser, sinon annuler, cette différence, qui peut notamment conduire à des disparités intempestives de caractéristiques, et, en particulier, de teintes, entre les substrats ainsi traités, il est connu d'interposer, entre la source émettrice et le support portant les différents substrats à traiter, un cache de répartition de configuration appropriée.

Cela est le cas, par exemple, dans les brevets américains Nos 4 380 212 et 4 449 478.

Déterminée expérimentalement, la configuration du cache de répartition ainsi mis en oeuvre est telle que l'envergure de ce cache de répartition est par exemple plus importante à proximité de l'axe de rotation du support qu'à distance de cet axe de rotation.

Ainsi, le dépôt d'une couche de matériau sur les divers substrats traités peut sensiblement se faire suivant la même épaisseur pour l'ensemble de ceux-ci.

Mais, si ce cache de répartition permet ainsi d'optimiser l'épaisseur d'une couche, il en est malheureusement pas de même pour l'ensemble des couches.

Le cache de répartition, unique, mis en oeuvre, est alors optimisé pour l'une de ces couches, et, pour les autres, on s'efforce, quand cela est techniquement possible, d'agir sur d'autres paramètres, pour modifier en conséquence la forme du cône d'évaporation correspondant, en soumettant par exemple le matériau à évaporer à une préfusion plus ou moins prolongée.

Le plus souvent, cependant, la répartition des couches de faible épaisseur est plus ou moins négligée.

Ainsi, globalement, le résultat obtenu n'est pas toujours totalement satisfaisant, les divers substrats traités en même temps présentant à la sortie des caractéristiques qui, suivant leur position sur le support mis en oeuvre, ne sont pas rigoureusement identiques de l'un à l'autre d'entre eux.

Des essais ont été pratiqués pour accroître les possibilités d'intervention.

Par exemple, il a été proposé de prévoir, dans l'enceinte de traitement, deux caches de répartition différents, qui sont chacun individuellement adaptés au dépôt de deux couches différentes, et dont un seul est donc mis en oeuvre à chaque fois.

Mais une multiplication de tels caches de répartition différents en fonction d'un nombre plus élevé de couches à déposer deviendrait rapidement prohibitive.

Comme dans le document "Uniformity Déposition Corrector, October 1971", IBM Technical Disclosure Bulletin, vol. 14, no. 5, Octobre 1971, page 1572, XP002083820, il a été également déjà proposé de former le cache de répartition à l'aide d'un panneau d'occultation mobile.

Mais, comme précédemment, les possibilités d'adaptation d'un tel cache de répartition sont ainsi limitées.

La présente invention a d'une manière générale pour objet une disposition permettant au contraire une capacité d'adaptation accrue.

De manière plus précise, elle a tout d'abord pour objet un cache de répartition à mettre en oeuvre pour le contrôle du dépôt par évaporation d'un quelconque revêtement sur un quelconque substrat, ce cache de répartition comportant au moins un panneau d'occultation mobile et étant caractérisé en ce qu'il comporte au moins deux panneaux d'occultation, dits ci-après panneaux d'occultation latéraux, qui sont sensiblement coplanaires et qui sont montés pivotants par rapport à une embase formant un troisième panneau d'occultation fixe, pour pivoter sous le contrôle d'une commande qui leur est commune, de manière continue, entre deux positions extrêmes, à savoir, une position rapprochée, pour laquelle l'espace entre eux est minimal, et une position écartée, pour laquelle cet espace est au contraire maximal ; elle a encore pour objets toute enceinte de traitement mettant en oeuvre un tel cache de répartition et le procédé de réalisation d'un revêtement multicouches correspondant.

Grâce à la disposition suivant l'invention, il est avantageusement possible, pour chaque couche à déposer, d'optimiser la surface du cache de répartition mis en oeuvre, en ajustant au plus près la surface de celui-ci.

Il suffit, en effet, d'écarter plus ou moins l'un de l'autre les deux panneaux d'occultation latéraux de ce cache de répartition.

Il est ainsi sensiblement possible d'obtenir une même épaisseur pour la couche déposée sur chacun des substrats traités en même temps, et, de couche en couche, d'obtenir une bonne uniformité de caractéristiques pour l'ensemble de ces substrats.

Toute intervention plus ou moins aléatoire, sur d'autres paramètres, tels que le temps de préfusion, peut ainsi corollairement être avantageusement évitée.

En bref, le cache de répartition suivant l'invention constitue avantageusement un cache de répartition à surface variable, et, pour la réalisation d'un revêtement multicouches, il est ainsi avantageusement possible de modifier si nécessaire la surface de ce cache de répartition pour le dépôt de chacune des couches.

Les caractéristiques et avantages de l'invention ressortiront d'ailleurs de la description qui va suivre, à titre d'exemple, en référence aux dessins schématiques annexés sur lesquels :
la figure 1 est une vue en perspective d'un substrat à traiter ;
la figure 2 est, à échelle réduite, une vue en élévation-coupe d'une enceinte de traitement, qui est susceptible d'être mise en oeuvre pour le traitement de ce substrat, et dans laquelle intervient un cache de répartition suivant l'invention ;
la figure 3 est, à échelle supérieure, une vue en perspective de ce cache de répartition, vu de dessous, suivant la flèche III de la figure 2, avec une partie du support auquel il est associé ;
la figure 4 est, à échelle encore supérieure, et suivant la flèche IV de la figure 2, une vue de dessus du cache de répartition suivant l'invention, pour la position rapprochée des deux panneaux d'occultation latéraux qu'il comporte ;
la figure 5 reprend, à échelle encore supérieure, et avec un arrachement local, le détail de la figure 4 repéré par un encart V sur cette figure 4 ;
la figure 6 est une vue en perspective de l'embase fixe que comporte le cache de répartition suivant l'invention et de l'un des leviers par lesquels ses panneaux d'occultation latéraux sont montés pivotants sur cette embase ;
la figure 7 est, avec un arrachement local, une vue en perspective d'un de ces panneaux d'occultation latéraux, avec le levier qui le porte ;
la figure 8 est, à échelle différente, et suivant la flèche VIII de la figure 3, une vue de côté illustrant la fixation du cache de répartition suivant l'invention à l'attache à laquelle il est suspendu ;
la figure 9 est, également à échelle différente, une vue partielle en coupe de la commande de ce cache de répartition, suivant la ligne IX-IX de la figure 2;
la figure 10 est une vue de dessus analogue à celle de la figure 4, pour la position écartée des panneaux d'occultation latéraux du cache de répartition suivant l'invention.

Ces figures illustrent, à titre d'exemple, le cas où le substrat 10 à traiter est un palet de contour circulaire destiné à constituer une lentille ophtalmique après son débordage.

Il s'agit d'appliquer à ce substrat 10 un quelconque traitement, et, par exemple, un traitement antireflet, impliquant le dépôt sur lui, par évaporation, et, plus précisément, par évaporation sous vide, d'un revêtement comportant au moins une couche d'un quelconque matériau.

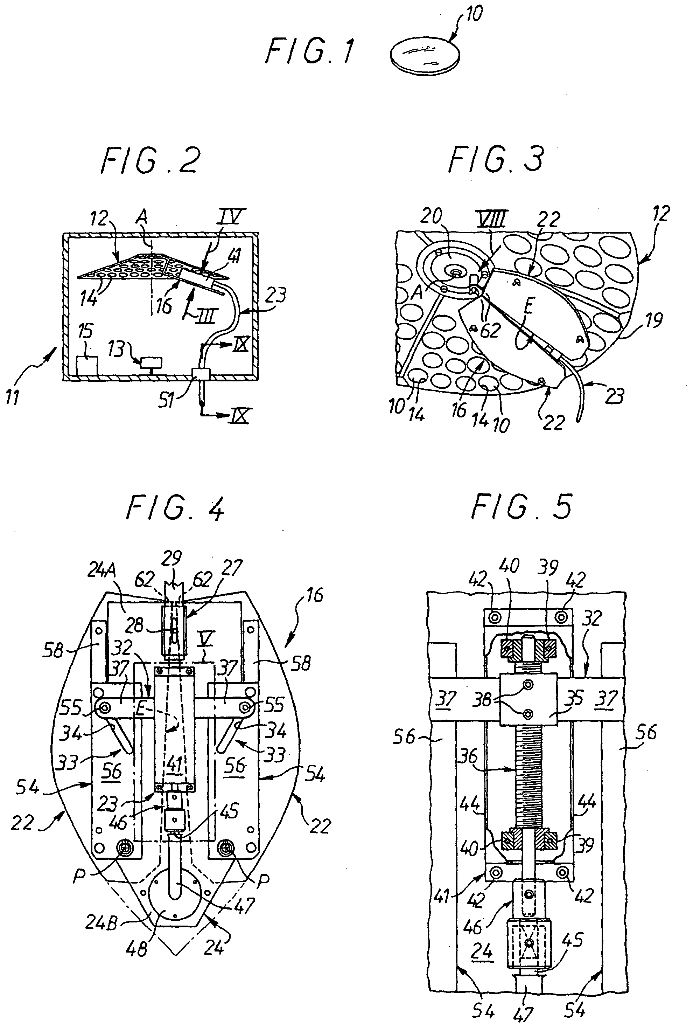

Tel que schématisé sur la figure 2, il est mis en oeuvre, à cet effet, une enceinte de traitement 11 comportant, intérieurement, un support 12, qui est monté rotatif autour d'un axe A, et une source émettrice 13, à partir de laquelle le matériau à déposer est évaporé.

Par exempte, et tel que représenté, le support 12 est en forme de calotte sphérique et son axe de rotation A s'étend suivant son axe de symétrie, en passant, donc, par sa zone centrale.

Quoi qu'il en soit, et ainsi qu'il est mieux visible sur la figure 3, le support 12 ainsi mis en oeuvre présente, usuellement, une pluralité d'emplacements 14, en pratique de simples ouvertures, propres à recevoir chacun un substrat 10 à traiter, par exemple par simple emboîtement.

Corollairement, la source émettrice 13 peut par exemple être constituée par un simple creuset, qui est disposé à l'aplomb du support 12, suivant l'axe de rotation A de celui-ci, et dans lequel est mis en place le matériau à évaporer.

Dans la forme de mise en oeuvre représentée, il a été supposé que l'évaporation de ce matériau était provoquée par bombardement électronique, et on a schématisé, en 15, sur la figure 2, le canon à électrons correspondant.

En pratique, le revêtement à réaliser implique le dépôt successif de plusieurs couches de matériau sur les substrats 10, et, d'une de ces couches à l'autre, les matériaux mis en oeuvre sont éventuellement différents.

Les dispositions qui précèdent sont bien connues par elles-mêmes, et ne relevant pas, en propre, de la présente invention, elles ne seront pas décrites plus en détail ici, notamment en ce qui concerne les moyens mis en oeuvre pour le soutien et l'entraînement en rotation du support 12.

De manière également connue en soi, il est mis en oeuvre, dans l'enceinte de traitement 11, un cache de répartition 16, qui intervient entre le support 12 et la source émettrice 13.

Globalement, ce cache de répartition 16 s'étend sensiblement parallèlement au support 12, en dessous de celui-ci.

Par exemple, et tel que représenté, il s'étend globalement radialement suivant toute la surface utile du support 12, jusqu'à la périphérie 19 de celui-ci.

Dans la forme de réalisation représentée, et suivant des dispositions qui seront décrites plus en détail ultérieurement, le cache de répartition 16 s'étend en porte à faux à compter d'une attache fixe 20 qui entoure l'axe de rotation A du support 12.

De manière connue en soi, le cache de répartition 16 mis en oeuvre suivant l'invention comporte au moins deux panneaux d'occultation 22 distincts, dont un est monté mobile.

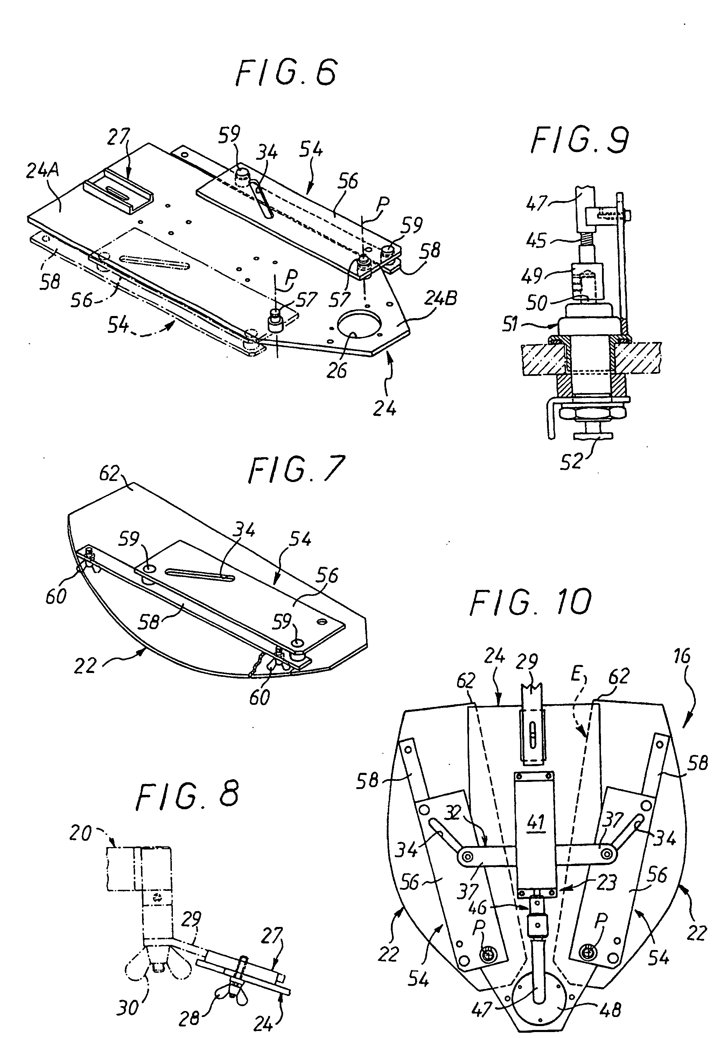

Suivant l'invention, ces deux panneaux d'occultation 22, dits ci-après par simple commodité panneaux d'occultation latéraux, sont sensiblement coplanaires l'un avec l'autre, et, sous le contrôle d'une commande 23, qui leur est commune, et qui sera détaillée ultérieurement, ils sont l'un et l'autre montés mobiles, de manière continue, entre deux positions extrêmes, à savoir, une position rapprochée, pour laquelle, tel que représenté sur la figure 4, l'espace E entre eux est minimal, et une position écartée, pour laquelle, tel que représenté sur la figure 10, cet espace E est au contraire maximal.

Dans la forme de réalisation représentée, les deux panneaux d'occultation latéraux 22 sont l'un et l'autre montés pivotants par rapport à une embase 24, qui est fixe.

Leurs axes de pivotement P, qui interviennent à distance l'un de l'autre, sont sensiblement parallèles l'un à l'autre, et ils s'étendent sensiblement perpendiculairement au support 12.

Ces axes de pivotement P sont repérés par leur trace sur les figures 4 et 10, et ils sont schématisés en traits interrompus sur la figure 6.

Dans la forme de réalisation représentée, l'embase 24 se présente sous la forme générale d'une plaque.

Elle forme ainsi un troisième panneau d'occultation, ou panneau d'occultation médian, et les deux panneaux d'occultation latéraux 22 s'étendent sensiblement parallèlement à elle.

Les axes de pivotement P des panneaux d'occultation latéraux 22 sont donc sensiblement perpendiculaires à cette embase 24.

Dans la forme de réalisation représentée, l'embase 24 comporte, du côté de l'axe de rotation A du support 12, une partie avant 24A, de contour rectangulaire, par laquelle se fait sa fixation à l'attache fixe 20, et, du côté de la périphérie 19 du support 12, une partie arrière 24B, de contour trapézoïdal, qui, pour des raisons qui apparaîtront ci-après, présente une ouverture circulaire 26.

Les axes de pivotement P des panneaux d'occultation latéraux 22 interviennent sensiblement à la jonction entre ces deux parties avant 24A et arrière 24B.

Bien entendu, ces deux parties avant 24A et arrière 24B de l'embase 24 sont en continu l'une avec l'autre.

Pour la fixation à l'attache fixe 20, la partie avant 24A est équipée d'une coulisse 27 par laquelle l'ensemble est monté réglable en position, sous le contrôle d'une vis papillon 28, sur une patte 29, qui, tel que schématisé en traits interrompus sur la figure 8, est elle-même rapportée sur l'attache fixe 20 par une vis papillon 30.

Dans la forme de réalisation représentée, la commande 23 commune aux deux panneaux d'occultation latéraux 22 comporte, du côté de la surface supérieure de l'embase 24, c'est-à-dire du côté de la surface de celle-ci tournée vers le support 12, un palonnier 32, qui est monté mobile sur l'embase 24, et qui engrène avec ces panneaux d'occultation latéraux 22 par des montages à boutonnière 33 dont les boutonnières 34 sont globalement obliques l'une par rapport à l'autre.

En pratique, le palonnier 32 s'étend parallèlement au plan passant par les axes de pivotement P des panneaux d'occultation latéraux 22.

Par sa partie médiane, le palonnier 32 est solidaire d'une noix taraudée 35 qui est en prise avec une tige filetée 36 montée rotative sur l'embase 24, le long de la ligne médiane de celle-ci.

Par exemple, et tel que représenté, figures 4 et 5, le palonnier 32 comporte deux bras 37, à raison d'un pour chacun des panneaux d'occultation latéraux 22, et ces deux bras 37 s'étendent chacun respectivement, dos à dos, à compter de la noix taraudée 35, en étant dûment solidarisés à celle-ci, par exemple par des vis 38.

Corollairement, dans la forme de réalisation représentée, la tige filetée 36 s'étend entre deux paliers 39 dûment solidarisés à l'embase 24, par exemple par des vis 40, et l'ensemble est disposé à l'abri d'un capot 41, qui est lui-même rapporté sur l'embase 24, par exemple par des vis 42, et qui présente, latéralement, des fentes 44 pour le passage des bras 37 du palonnier 32.

Dans la forme de réalisation représentée, la commande 23 commune aux deux panneaux d'occultation latéraux 22 du cache de répartition 16 suivant l'invention est accessible de l'extérieur de l'enceinte de traitement 11.

Par exemple, et tel que représenté, la tige filetée 36 de cette commande 23 est calée en rotation sur un flexible d'entraînement 45 par un raccord 46, et, à l'abri d'une gaine 47, ce flexible d'entraînement 45 traverse l'embase 24 à la faveur de l'ouverture circulaire 26 de sa partie arrière 24B, un embout 48 rapporté sur l'embase 24 au droit de cette ouverture circulaire 26 assurant au passage le maintien de l'ensemble.

A son autre extrémité, et ainsi qu'il est visible sur la figure 9, le flexible d'entraînement 45 est attelé, par un autre raccord 49, à une tige 50, qui, par un joint tournant 51, fait issue hors de l'enceinte de traitement 11, à la partie basse de celle-ci, et qui, à l'extérieur de cette enceinte de traitement 11, est en prise avec une quelconque commande en rotation 52.

Les dispositions qui précèdent ne relevant pas, en propre, de la présente invention, elles ne seront pas décrites plus en détail ici.

Dans la forme de réalisation représentée, chacun des deux panneaux d'occultation latéraux 22 du cache de répartition 16 suivant l'invention est rapporté de manière amovible sur un levier de support 54, qui est monté pivotant sur l'embase 24, et par l'intermédiaire duquel intervient la commande 23 qui leur est commune.

Par exemple, et tel que représenté, la boutonnière 34 du montage à boutonnière 33 par lequel le palonnier 32 de cette commande 23 engrène avec un tel panneau d'occultation latéral 22 évide localement le levier de support 54 sur lequel est rapporté ce panneau d'occultation latéral 22, et, en correspondance, le palonnier 32 porte un pion 55, figure 4, qui est engagé à frottement doux dans cette boutonnière 34.

Dans la forme de réalisation représentée, le levier de support 54 de chacun des deux panneaux d'occultation latéraux 22 s'étend au moins pour partie d'un premier côté de l'embase 24, et, plus précisément, du côté de la surface supérieure de celle-ci, pour permettre à la commande 23 d'intervenir sur lui, et le panneau d'occultation latéral 22 correspondant s'étend au contraire au moins pour partie de l'autre côté de cette embase 24, et, plus précisément, du côté de la surface inférieure de cette dernière, c'est-à-dire du côté de la surface de cette embase 24 tournée du côté opposé au support 12.

Par exemple, et tel que représenté, le levier de support 54 de chacun des deux panneaux d'occultation latéraux 22 comporte, d'une part, du côté de la surface supérieure de l'embase 24, un flasque 56, qui comporte la boutonnière 34 correspondante, et qui est monté pivotant sur un goujon 57 porté par l'embase 24 pour matérialiser son axe de pivotement P, et, d'autre part, du côté de la surface inférieure de l'embase 24, une barrette 58, qui est suspendue au flasque 56, en étant attelée à celui-ci par deux colonnettes 59, et sur laquelle le panneau d'occultation latéral 22 concerné est rapporté à l'aide de vis papillon 60.

Il est ainsi avantageusement possible de déposer ces panneaux d'occultation latéraux 22 après une utilisation, en vue de leur nettoyage, ce qui facilite celui-ci

II est ainsi également possible de substituer si désiré à des panneaux d'occultation latéraux 22 de configuration donnée d'autres panneaux d'occultation latéraux 22 présentant une autre configuration.

Dans la forme de réalisation représentée, les panneaux d'occultation latéraux 22, qui sont identiques l'un à l'autre, ont un contour en plan globalement rectangulaire, mais leur côté longitudinal le plus extérieur est cependant curviligne, et, plus précisément, convexe.

Ils présentent donc, chacun, sur leur côté longitudinal le plus intérieur, à l'extrémité de celui-ci opposée à leur axe de pivotement P, une zone d'angle 62.

Quoi qu'il en soit, le cache de répartition 16 suivant l'invention admet, préférentiellement, un plan de symétrie, qui passe par la ligne médiane de son embase 24, en s'étendant en pratique suivant une direction radiale du support 12, et vis-à-vis duquel les deux panneaux d'occultation latéraux 22 sont mobiles en sens opposés l'un par rapport à l'autre.

Dans la forme de réalisation représentée, l'axe de pivotement P de ces panneaux d'occultation latéraux 22 est plus éloigné de l'axe de rotation A du support 12 que la zone d'action sur eux de la commande 23 qui leur est commune, en l'espèce le montage à boutonnière 33 par lequel le palonnier 32 de cette commande 23 engrène avec leur levier de support 54.

Conjointement, dans cette forme de réalisation, les boutonnières 34 des deux montages à boutonnière 33 en jeu convergent l'une vers l'autre en direction opposée à l'axe de rotation A du support 12.

Dans la forme de réalisation représentée, enfin, les deux panneaux d'occultation latéraux 22 sont au moins localement en contact l'un avec l'autre lorsqu'ils sont en position rapprochée, tel que représenté à la figure 4.

Par exemple, et tel que représenté, lorsqu'ils sont ainsi en position rapprochée, ils ne sont au contact l'un de l'autre que ponctuellement, par une zone d'angle, en l'espèce leur zone d'angle 62, et l'espace E qu'ils ménagent alors entre eux a un contour en plan globalement triangulaire dont la pointe est dirigée vers l'axe de rotation A du support 12.

Conjointement, le palonnier 32 de la commande 23 s'étend alors du côté de la partie avant de la tige filetée 36, c'est-à-dire du côté de celle-ci la plus proche de l'axe de rotation A du support 12.

Lorsque la commande 23 est actionnée, le palonnier 32 se déplace parallèlement à lui-même le long de la tige filetée 36, et il provoque un écartement progressif des deux panneaux d'occultation latéraux 22 l'un par rapport à l'autre.

Les deux panneaux d'occultation latéraux 22 se déploient alors latéralement, de part et d'autre de l'embase 24, tout se passant comme si ils venaient ainsi progressivement accroître l'envergure de cette dernière du côté de l'axe de rotation A du support 12.

En fin de course, le palonnier 32 s'étend du côté de la partie arrière de la tige filetée 36, c'est-à-dire du côté de celle-ci la plus éloignée de l'axe de rotation A du support 12, et les deux panneaux d'occultation latéraux 22 sont donc en position écartée, tel que représenté sur la figure 10.

L'espace E qu'ils ménagent alors entre eux a encore un contour en plan globalement triangulaire, mais la pointe de ce contour est alors dirigée du côté opposé à l'axe de rotation A du support 12.

Grâce à la commande 23, et ainsi qu'il est aisé de le comprendre, les deux panneaux d'occultation latéraux 22 peuvent par ailleurs occuper en continu n'importe quelle position intermédiaire entre leur position rapprochée et leur position écartée.

Il résulte de ce qui précède que, pour la réalisation d'un revêtement multicouches pour le traitement d'un ensemble de substrats 10, on met en oeuvre, suivant l'invention, dans l'enceinte de traitement 11 à évaporation sous vide correspondante, un cache de répartition 16 à surface variable, du type par exemple de celui décrit ci-dessus, et on modifie la surface de ce cache de répartition 16 pour le dépôt de l'une au moins des couches, et, par exemple, suivant les nécessités, pour le dépôt de chacune de celles-ci.

Par exemple, lorsque les substrats 10 traités sont des lentilles ophtalmiques, le revêtement déposé comprend des couches telles que le traitement qui en résulte pour ces substrats 10 est un traitement antireflet.

Par exemple, également, ce revêtement comporte au moins deux couches de matériaux différents.

Si désiré, les substrats 10 sont chauffés thermiquement avant le dépôt du revêtement.

Si désiré, également, ils subissent un bombardement ionique avant le dépôt du revêtement, l'intensité de ce bombardement ionique étant par exemple ajustée en modifiant la surface du cache de répartition 16.

De même, le dépôt du revêtement peut être assisté par un bombardement ionique si désiré.

La présente invention ne se limite d'ailleurs pas à la forme de réalisation décrite et représentée, mais englobe toute variante d'exécution.

En outre, son domaine d'application s'étend à n'importe quelle technique d'évaporation sous vide, et, notamment, à celle à cible magnétron, pour laquelle, les substrats à traiter étant placés au voisinage du ou des matériaux à évaporer, les problèmes d'uniformité des couches se posent de façon encore plus cruciale.

Il suffit, si nécessaire, d'adapter en conséquence la forme du cache de répartition mis en oeuvre.

## Revendications

1. Cache de répartition à mettre en oeuvre pour le contrôle du dépôt par évaporation d'un quelconque revêtement sur un quelconque substrat, ce cache de répartition comportant au moins un panneau d'occultation (22) mobile et étant **caractérisé en ce qu'**il comporte au moins deux panneaux d'occultation (22), dits ci-après panneaux d'occultation latéraux, qui sont sensiblement coplanaires et qui sont montés pivotants par rapport à une embase (24) formant un troisième panneau d'occultation fixe, pour pivoter sous le contrôle d'une commande (23) qui leur est commune, de manière continue, entre deux positions extrêmes, à savoir, une position rapprochée, pour laquelle l'espace (E) entre eux est minimal, et une position écartée, pour laquelle cet espace (E) est au contraire maximal.

2. Cache de répartition suivant la revendication 1, **caractérisé en ce que** la commande (23) commune aux deux panneaux d'occultation latéraux (22) comporte un palonnier (32), qui est monté mobile sur l'embase (24), et qui engrène avec ces panneaux d'occultation latéraux (22) par des montages à boutonnière (33) dont les boutonnières (34) sont globalement obliques l'une par rapport à l'autre.

3. Cache de répartition suivant la revendication 2, **caractérisé en ce que**. par sa partie médiane, le palonnier (32) est solidaire d'une noix taraudée (35) qui est en prise avec une tige filetée (36) montée rotative sur l'embase (24).

4. Cache de répartition suivant l'une quelconque des revendications 1 à 3. **caractérisé en ce que** chacun des deux panneaux d'occultation latéraux (22) est rapporté de manière amovible sur un levier de support (54), qui est monté pivotant sur l'embase (24), et par l'intermédiaire duquel intervient la commande (23) qui leur est commune.

5. Cache de répartition suivant les revendications 2 et 4, prises conjointement, **caractérisé en ce que** la boutonnière (34) du montage à boutonnière (33) par lequel le palonnier (32) engrène avec un panneau d'occultation latéral (22) évide localement le levier de support (54) sur lequel est rapporté ce panneau d'occultation latéral (22), et, en correspondance, le palonnier (32) porte un pion (55) qui est engagé dans cette boutonnière (34).

6. Cache de répartition suivant l'une quelconque des revendications 4, 5 **caractérisé en ce que** le levier de support (54) de chacun des deux panneaux d'occultation latéraux (22) s'étend au moins pour partie d'un premier côté de l'embase (24), et le panneau d'occultation latéral (22) correspondant s'étend au moins pour partie de l'autre côté de cette embase (24).

7. Cache de répartition suivant l'une quelconque des revendications 1 à 6, **caractérisé en ce que** les deux panneaux d'occultation latéraux (22) s'étendent sensiblement parallèlement à l'embase (24).

8. Cache de répartition suivant la revendication 7, **caractérisé en ce que**, en position rapprochée, les deux panneaux d'occultation latéraux (22) sont au moins localement en contact l'un avec l'autre.

9. Cache de répartition suivant la revendication 8, **caractérisé en ce que**, en position rapprochée, les deux panneaux d'occultation latéraux (22) ne sont au contact l'un de l'autre que ponctuellement, par une zone d'angle (62), et l'espace (E) qu'ils ménagent alors entre eux a un contour en plan globalement triangulaire.

10. Cache de répartition suivant l'une quelconque des revendications 1 à 9, **caractérisé en ce qu'**il admet un plan de symétrie vis-à-vis duquel les deux panneaux d'occultation latéraux (22) sont mobiles en sens opposés l'un par rapport à l'autre.

11. Enceinte de traitement pour le dépôt par évaporation d'un revêtement sur un substrat, comportant, intérieurement, un support (12), qui, monté rotatif, présente une pluralité d'emplacements (14) propres à recevoir chacun un substrat (10) à traiter, une source émettrice (13), à partir de laquelle le matériau à déposer est évaporé. et un cache de répartition (16) qui intervient entre le support (12) et la source émettrice (13), **caractérisée en ce que** le cache de répartition (16) est conforme à l'une quelconque des revendications 1 à 10.

12. Enceinte de traitement suivant la revendication 11, **caractérisée en ce que** le cache de répartition (16) s'étend sensiblement parallèlement au support (12).

13. Enceinte de traitement suivant la revendication 12, **caractérisée en ce que** le cache de répartition étant conforme à la revendication 2, l'axe de pivotement (P) de ses panneaux d'occultation latéraux (22) est plus éloigné de l'axe de rotation (A) du support (12) que la zone d'action sur eux de la commande (23) qui leur est commune.

14. Enceinte de traitement suivant l'une quelconque des revendications 11 à 13, **caractérisée en ce que** le cache de répartition (16) s'étend en porte à faux à compter d'une attache fixe (20) qui entoure l'axe de rotation (A) du support (12).

15. Enceinte de traitement suivant l'une quelconque des revendications 11 à 14, **caractérisée en ce que** la commande (23) commune aux deux panneaux d'occultation latéraux (22) du cache de répartition (16) est accessible de l'extérieur.

16. Procédé de réalisation d'un revêtement multicouches pour le traitement d'un ensemble de substrats (10) par évaporation sous vide, du genre suivant lequel les substrats (10) sont disposés dans une enceinte de traitement (11) à évaporation sous vide contenant un cache de répartition (16), **caractérisé en ce que** le cache de répartition (16) mis en oeuvre est un cache de répartition à surface variable suivant l'une quelconque des revendications 1 à 10, et la surface de ce cache de répartition (16) est modifiée pour le dépôt de chacune des couches.

17. Procédé suivant la revendication 16, **caractérisé en ce que** le revêtement comprend des couches telles que le traitement qui en résulte pour les substrats (10) est un traitement antireflet.

18. Procédé suivant l'une quelconque des revendications 16, 17, **caractérisé en ce que** le revêtement comporte au moins deux couches de matériaux différents.

19. Procédé suivant l'une quelconque des revendications 16 à 18 **caractérisé en ce que** les substrats (10) sont chauffés thermiquement avant le dépôt du revêtement.

20. Procédé suivant l'une quelconque des revendications 16 à 19, **caractérisé en ce que** les substrats (10) subissent un bombardement ionique avant le dépôt du revêtement.

21. Procédé suivant la revendication 20, **caractérisé en ce que** l'intensité du bombardement ionique est ajustée en modifiant la surface du cache de répartition (16).

22. Procédé suivant l'une quelconque des revendications 16 à 21, **caractérisé en ce que** le dépôt du revêtement est assisté par un bombardement ionique.

23. Procédé suivant l'une quelconque des revendications 16 à 22, **caractérisé en ce que** le cache de répartition (16) comporte au moins deux panneaux d'occultation (22).

24. Procédé suivant la revendication 23, **caractérisé en ce que** les deux panneaux d'occultation (22) sont montés mobiles.

25. Procédé suivant l'une quelconque des revendications 16 à 24, **caractérisé en ce que** les substrats (10) traités sont des lentilles ophtalmiques.

## Patentansprüche

1. Verteilerblende zum Einsatz für die Steuerung des Verdampfungsniederschlages bzw. der Verdampfungsfällung einer beliebigen Beschichtung an einem beliebigen Substrat, wobei die Verteilerblende zumindest zwei bewegliche Verdunklungs- oder Sperrschilder (22) umfasst und **dadurch gekennzeichnet** ist, dass sie zumindest zwei Verdunklungs- oder Sperrschilder (22) umfasst, im folgenden Lateralsperr- oder Verdunklungsschilder genannt, welche im wesentlichen koplanar vorliegen und welche schwenkbar mit Bezug auf eine Basis (24) montiert sind, welche ein drittes feststehendes Sperr- oder Verdunklungsschild bildet, um schwenkbar zu sein unter der Steuerung einer Steuereinrichtung (23), die ihnen gemeinsam ist, und zwar in kontinuierlicher Weise zwischen zwei Endpositionen, nämlich einer angenäherten Position, in welcher der Raum (E) zwischen ihnen minimal ist, und einer beabstandeten Position, in welcher dieser Raum (E) im Gegenteil maximal ist.

2. Verteilerblende nach Anspruch 1, **dadurch gekennzeichnet, dass** die Steuerung (23), die den zwei Lateralsperrschildern (22) gemeinsam ist, eine Traverse (32) umfasst, die beweglich an der Basis (24) montiert ist und die mit den Lateralsperr- oder Verdunklungsschildem (22) mittels Langlochmontagen (33) in Eingriff steht, deren Langlöcher (34) generell schräg mit Bezug zueinander vorgesehen sind.

3. Verteilerblende nach Anspruch 2, **dadurch gekennzeichnet, dass** die Traverse (32) über ihren mittleren Abschnitt mit einer gewindeten Nuss bzw. Mutter (35) verbunden bzw. einstückig ausgebildet ist, die mit einem Gewindeschaft (36) in Eingriff steht, der drehbar an der Basis (24) montiert ist.

4. Verteilerblende nach einem der Ansprüche 1 bis 3, **dadurch gekennzeichnet, dass** jeder der zwei Lateralsperr- oder Verdunklungsschilder (22) in beweglicher oder lösbarer Weise an einem Stützhebel (54) angebracht ist, welcher schwenkbar an der Basis (24) montiert ist und mittels welchem die ihnen gemeinsame Steuerung (23) einwirkt.

5. Verteilerblende nach den Ansprüchen 2 und 4 gemeinsam, **dadurch gekennzeichnet, dass** das Langloch (34) der Langlochmontage (33), durch welche die Traverse (32) mit einem Lateralsperrschild (22) in Eingriff steht, lokal den Stützhebel (54) ausspart, an welchem dieser Lateralsperrschild (22) befestigt ist, wobei entsprechend die Traverse (32) einen Zapfen (55) trägt, der in dieses Langloch (34) eingreift oder eingegriffen ist.

6. Verteilerblende noch einem der Ansprüche 4 oder 5, **dadurch gekennzeichnet, dass** der Stützhebel (54) von jedem der zwei Lateralsperrschilder (22) sich zumindest teilweise an einer ersten der Seiten der Basis (24) erstreckt, wobei sich das entsprechende Lateralsperrschild (22) zumindest teilweise an der anderen Seite der Basis (24) erstreckt.

7. Verteilerblende nach einem der Ansprüche 1 bis 6, **dadurch gekennzeichnet, dass** die zwei Lateralsperrschilder (22) sich im wesentlichen parallel zur Basis (24) erstrecken.

8. Verteilerblende nach Anspruch 7, **dadurch gekennzeichnet, dass** in der angenäherten Position die zwei Lateralsperrschilder (22) zumindest lokal miteinander in Berührung stehen.

9. Verteilerblende nach Anspruch 8, **dadurch gekennzeichnet, dass** in der angenäherten Position die zwei Lateralsperrschilder (22) miteinander lediglich punktuell in Berührung stehen, und zwar über eine Winkelzone (62), wobei der Raum (E), den sie somit zwischen sich ausbilden, eine generell dreiecksförmige Kontur aufweist.

10. Verteilerblende nach einem der Ansprüche 1 bis 9, **dadurch gekennzeichnet, dass** sie eine Symmetrieebene zulässt, bezüglich welcher die zwei Lateralsperr- bzw. Verdunklungsschilder (22) beweglich in entgegengesetzter Richtung mit Bezug zueinander sind.

11. Behandlungsgehäuse oder -anlage zur Dampffällung einer Beschichtung an einem Substrat, umfassend innertich eine Stütze (12), die drehbar montiert eine Vielzahl von Orten (14) aufweist, die jeweils ein zu behandelndes Substrat (10) aufnehmen können, eine Emittierquelle (13) ausgehend von welcher das zu fällende bzw. niederzuschlagende Material verdampft wird, sowie eine Verteilerblende (16), die zwischen der Stütze (12) und der Emittierquelle (13) einwirkt, **dadurch gekennzeichnet, dass** die Verteilerblende (16) einem der Ansprüche 1 bis 10 entspricht.

12. Behandlungsgehäuse oder -anlage nach Anspruch 11, **dadurch gekennzeichnet, dass** die Verteilerblende (16) sich im wesentlichen parallel zur Stütze (12) erstreckt.

13. Behandlungsgehäuse oder -anlage nach Anspruch 12, **dadurch gekennzeichnet, dass** die Verteilerblende dem Anspruch 2 entspricht, wobei die Schwenkachse (P) ihrer Lateralsperr- oder Verdunklungsschilder (22) stärker von der Rotationsachse (A) der Stütze (12) beabstandet ist als die Wirkzone bzw. -fläche an ihnen von der ihnen gemeinsamen bzw. zugeordneten Steuerung (23).

14. Behandlungsgehäuse oder -anlage nach einem der Ansprüche 11 bis 13, **dadurch gekennzeichnet, dass** die Verteilerblende (16) sich fliegend von einer feststehenden Befestigung (20) erstreckt, welche die Rotationsachse (A) der Stütze (12) umgibt.

15. Behandlungsgehäuse oder -anlage nach einem der Ansprüche 11 bis 14, **dadurch gekennzeichnet, dass** die Steuerung (23), die den zwei Lateralsperrschildem (22) der Verteilerblende (16) gemeinsam ist, äußerlich zugänglich ist.

16. Verfahren zur Darstellung einer Mehrschichtbeschichtung bzw. eines Mehrschichtüberzuges zur Behandlung mehrerer Substrate (10) mittels Vakuum- oder Unterdruckverdampfung von der Art, bei welcher die Substrate (10) in einem Behandlungsgehäuse bzw. einer Behandlungsanlage bzw. einer Behandlungskammer (11) zur Verdampfung im Vakuum bzw. im Unterdruck angeordnet sind, eine Verteilerblende (16) enthaltend, **dadurch gekennzeichnet, dass** die verwendete Verteilerblende (16) eine Verteilerblende mit variabler Fläche gemäß einem der Ansprüche 1 bis 10 ist, wobei die Fläche der Verteilerblende (16) zum Niederschlag bzw. zur Fällung von jeder der Schichten verändert oder modifiziert ist bzw. wird.

17. Verfahren nach Anspruch 16, **dadurch gekennzeichnet, dass** der Überzug bzw. die Beschichtung Schichten umfasst, wie auch die daraus resultierende Behandlung für die Substrate (10) eine Antireflexbehandlung ist.

18. Verfahren nach einem der Ansprüche 16 und 17, **dadurch gekennzeichnet, dass** der Überzug oder die Beschichtung zumindest zwei Schichten aus unterschiedlichem Material umfasst.

19. Verfahren nach einem der Ansprüche 16 bis 18, **dadurch gekennzeichnet, dass** die Substrate (10) thermisch vor dem Niederschlag oder der Fällung der Beschichtung oder des Überzuges erwärmt werden.

20. Verfahren nach einem der Ansprüche 16 bis 19, **dadurch gekennzeichnet, dass** die Substrate (10) einem lonenbeschuss vor dem Niederschlag oder der Fällung der Beschichtung oder des Überzuges ausgesetzt sind oder werden.

21. Verfahren nach Anspruch 20, **dadurch gekennzeichnet, dass** die Intensität des lonenbeschusses eingestellt ist oder wird, indem die Fläche der Verteilerblende (16) verändert wird.

22. Verfahren nach einem der Ansprüche 16 bis 21, **dadurch gekennzeichnet, dass** die Fällung oder der Niederschlag der Beschichtung oder des Überzuges von einem lonenbeschuss begleitet wird.

23. Verfahren nach einem der Ansprüche 16 bis 22, **dadurch gekennzeichnet, dass** die Verteilerblende (16) zumindest zwei Sperr- oder Verdunklungsschilder (22) umfasst.

24. Verfahren nach Anspruch 23, **dadurch gekennzeichnet, dass** die zwei Sperr- oder Verdunklungsschilder (22) beweglich montiert sind.

25. Verfahren nach einem der Ansprüche 16 bis 24, **dadurch gekennzeichnet, dass** die behandelten Substrate (10) ophthalmische Linsen sind.

## Claims

1. Mask used to control the deposition by evaporation of a coating of any kind onto a substrate of any kind, the mask including at least one mobile covering panel (22), **characterized in that** it includes at least two covering panels (22), referred to hereinafter as lateral covering panels, which are substantially coplanar and which are pivoted to a base (24) forming a third fixed covering panel in order to pivot, under the control of a common actuator (23), continuously between two extreme positions, namely a close together position in which the space (E) between them is minimal and a spread apart position in which that space (E) is maximal.

2. Mask according to claim 1, **characterized in that** the actuator (23) common to the two lateral covering panels (22) includes a swing-arm (32) mobile on the base (24) and interengaging with the lateral covering panels (22) through buttonhole arrangements (33) the buttonholes (34) of which are globally oblique to each other.

3. Mask according to claim 2, **characterized in that** the middle part of the swing-arm (32) is fastened to a screwthreaded nut (35) which is interengaged with a screwthreaded rod (36) rotatably mounted on the base (24).

4. Mask according to any one of claims 1 to 3, **characterized in that** each of the two lateral covering panels (22) is removably attached to a support lever (54) which is pivoted to the base (24) and through which their common actuator (23) operates.

5. Mask according to claim 2 in conjunction with claim 4, **characterized in that** the buttonhole (34) of the buttonhole arrangement (33) by which the swing-arm (32) is interengaged with a lateral covering panel (22) forms a localised opening in the support lever (54) to which that lateral covering panel (22) is attached and the swing-arm (32) carries in corresponding relation thereto a pin (55) which is engaged in that buttonhole (34).

6. Mask according to claim 4 or claim 5, **characterized in that** the support lever (54) of each of the two lateral covering panels (22) extends at least in part from a first side of the base (24) and the corresponding lateral covering panel (22) extends at least partly from the other side of said base (24).

7. Mask according to any one of claims 1 to 6, **characterized in that** the two lateral covering panels (22) are substantially parallel to the base (24).

8. Mask according to claim 7, **characterized in that**, in their close together position, the two lateral covering panels (22) are at least locally in contact with each other.

9. Mask according to claim 8, **characterized in that**, in their close together position, the two lateral covering panels (22) are in contact with each other only at a point, in a corner area (62), and the space (E) between them then has a globally triangular contour in plane view.

10. Mask according to any one of claims 1 to 9, **characterized in that** it has a plane of symmetry relative to which the two lateral covering panels (22) are mobile relative to each other in opposite directions.

11. Treatment enclosure for the deposition by evaporation of a coating on a substrate, having inside it a rotatable support (12) having a plurality of locations (14) each adapted to receive a substrate (10) to be treated, an emitter source (13) from which the material to be deposited is evaporated, and a mask (16) operative between the support (12) and the emitter source (13), **characterized in that** the mask (16) is a mask according to any one of claims 1 to 10.

12. Treatment enclosure according to claim 11, **characterized in that** the mask (16) is substantially parallel to the support (12).

13. Treatment enclosure according to claim 12, **characterized in that** the mask is a mask according to claim 2 and the pivot axis (P) of each of its lateral covering panels (22) is at a greater distance from the rotation axis (A) of the support (12) than the area in which their common actuator (23) acts on them.

14. Treatment enclosure according to any one of claims 11 to 13, **characterized in that** the mask (16) extends cantilever fashion from a fixed attachment (20) around the rotation axis (A) of the support (12).

15. Treatment enclosure according to any one of claims 11 to 14, **characterized in that** the actuator (23) common to the two lateral covering panels (22) of the mask (16) is accessible from the outside.

16. Method of producing a multilayer coating for treating a set of substrates (10) by evaporation in a vacuum, of the kind in which the substrates (10) are disposed in a vacuum evaporation treatment enclosure (11) containing a mask (16), **characterized in that** the mask (16) is a variable surface area mask according to any one of claims 1 to 10 and the surface area of the mask (16) is modified to deposit each of the layers.

17. Process according to claim 16, **characterized in that** the coating comprises layers such that the resulting treatment of the substrates (10) is an antireflection treatment.

18. Process according to claim 16 or claim 17, **characterized in that** the coating comprises at least two layers of different materials.

19. Process according to any one of claims 16 to 18, **characterized in that** the substrates (10) are heated before depositing the coating.

20. Process according to any one of claims 16 to 19, **characterized in that** the substrates (10) undergo ionic bombardment before depositing the coating.

21. Process according to claim 20, **characterized in that** the intensity of the ionic bombardment is adjusted by modifying the surface area of the mask (16).

22. Process according to any one of claims 16 to 21, **characterized in that** the deposition of the coating is assisted by ionic bombardment.

23. Process according to any one of claims 16 to 21, **characterized in that** the mask (16) includes at least two covering panels (22).

24. Process according to claim 23, **characterized in that** the two covering panels (22) are mobile.

25. Process according to any one of claims 16 to 24, **characterized in that** the substrates (10) treated are ophthalmic lenses.
